# EUROPEAN PATENT SPECIFICATION

(11) **EP 0 931 177 B1**
(45) Date of publication and mention of the grant of the patent: **12.06.2002**
(21) Application number: 97945148.1
(22) Date of filing: 09.10.1997
(51) Int. Cl.: C23C 16/26, B23B 27/20

(54) **POST TREATED DIAMOND COATED BODY**
NACHBEHANDELTER DIAMANTBESCHICHTETER KÖRPER
SUBSTRAT REVETU D'UNE COUCHE DE DIAMANT ET SOUMIS A UN POST-TRAITEMENT

(30) Priority: 10.10.1996 SE 9603721
(43) Date of publication of application: 28.07.1999
(73) Proprietor: SANDVIK AKTIEBOLAG, 811 81 Sandviken (SE)
(72) Inventor: REINECK, Ingrid, S-141 72 Huddinge (SE); EDHOLM, Bengt, S-752 28 Uppsala (SE); STRONDL, Christian, S-752 41 Uppsala (SE)
(74) Representative: Taquist, Lennart
(86) International application number: PCT/SE97/01689
(87) International publication number: WO 98/15670

(56) References cited:
- EP-A- 0 392 125
- EP-A- 0 614 998
- WO-A-95/15258
- US-A- 5 500 077
- 198/SPIE, Volume 2286, 1994, IAN LLEWELLYN et al., "Plasma Etching and Deposition as a Method of Polishing CVD Diamond", pages 198-204.
- CHEMICAL ABSTRACTS, Volume 107, No. 26, 28 December 1987, (Columbus, Ohio, USA), page 283, Abstract No. 241265y; & JP,A,62 158 864 (SUMITOMO ELECTRIC INDUSTRIES, LTD.) 14 July 1987.

## Description

The present invention relates to a diamond coated body for which the diamond layer is smoothened which increases its wear and flaking resistance, in particular to be used as a cutting tool aimed for cutting Al-alloys containing e.g. Si and Cu as alloying elements and the like.

After many years of research efforts, the production of thin layers of diamond directly from the gas phase by CVD plasma technique for coating of cutting tools has been realised. Gas phase deposition of diamond on cemented carbide tools has been assessed by a variety of methods where the tailoring of the cemented carbide has proven to be of great importance.

The predominant growth manner for CVD plasma diamond layers is that the grain size grows markedly with deposition time. Typically, for a 6-10 µm thick diamond layer, the diamond grain size is 2-5 µm giving a surface roughness in this regime. One way to avoid the increase in grain size by growth time is to apply a bias voltage onto the tools which gives a smooth diamond surface but with the risk of achieving a deteriorated diamond quality. Besides, large scale production involving biasing puts demands on careful and hence more elaborate fixturing.

Smoothening of the diamond layers is generally regarded as being beneficial in cutting applications since the cutting forces are reduced upon lowering the coefficient of friction. Measurements of the coefficient of friction have shown that a much lower value is obtained for a polished CVD diamond layer compared to an as-deposited layer. A method for achieving a smooth diamond layer on cutting tools is mechanical polishing but due to the three-dimensional and often complicated shape, the polishing has only been possible to apply on flat rake surfaces or on a small part of the flank just below the cutting edge.

Polishing of diamond layers for electronic purposes, i.e. diamond layers on flat Si wafers and the like is known from the literature (see e.g. US pat. 5,500,077). The methods applied have been, for example, reactive ion etching using RF plasma generation with different gases such as O₂, CF₄ etc. A highly efficient etching process is described in Llewellyn et. al., SPIE Vol.2286, (1994) 198-204, still only for a two-dimensional set-up. Reactive ion etching (RIE) constitutes a combination of a chemical reaction and physical ion bombardment of a surface. Typical for RIE as compared with plasma etching in general is that the ion energies are high, this due to a low pressure during the process (<13.3 Pa) ((<100 mTorr)).

EP-A-614 998 discloses a diamond coated member which has a diamond crystal layer formed by vapour phase synthesis on a surface of a substrate. The diamond crystal layer is constituted of plate-shaped diamond crystals at least at an initial stage of crystal growth. The polycrystal film is formed by growth and coalescence of the plate-shaped diamond crystals, which is uniformly oriented and with a surface roughness (Rmax) of not larger than 0.2 µm. The diamond coated member has high hardness, high thermal conductivity, and high chemical stability.

EP-A-392 125 discloses an edged medical tool, such as scalpels and injection needles, is imparted with unexpectedly improved incisiveness by first providing a carbonaceous coating layer of 1 to 20 nm thickness having a crystalline structure of diamond by a method of plasma-induced vapour-phase deposition in an atmosphere of a mixture of hydrogen gas and a hydrocarbon gas at a microwave frequency of 1 to 10 GHz and then etching the thus formed diamondlike coating layer in a plasma of hydrogen gas to such an extent that the thus etched surface has a roughness of 0.5 to 5 nm.

WO 95/15258 discloses a diamond-coated tool or wear part and a process for making them. The process includes a sintering step. In that step, a substrate is sintered in an atmosphere and for a time and at a temperature so that superficial, exaggerated grain growth is promoted that imparts a surface roughness which may serve as anchoring sites during a subsequent diamond coating step which is performed by a vapour deposition technique. The diamond-coated tool or wear part includes a large grain substrate surface, and a high bond strength between the diamond coating and the substrate surface.

US 5,500,077 discloses a method of flattening diamond, including: forming a flat coating comprising a material different from diamond, on a surface of diamond having unevenness; and removing the coating and the unevenness of the surface of diamond by dry etching under a condition such that both of the coating and the diamond can be etched, thereby to smooth the surface of the diamond.

JP-A-62 158 864 discloses how to uniformly cover a surface at a suitable temperature with good quality hard carbon film, by preheating mixed gas flow of hydrocarbon and hydrogen under reduced pressure to be introduced into a reaction furnace to a prescribed temperature, further intermittently introducing the hydrocarbon.

It is surprising to find that reactive ion etching of diamond can be achieved for diamond layers on cemented carbide or cermet bodies of complex, three-dimensional shapes, such as cutting tools including chip-breakers on the top surface so as to provide chips formed during machining in a desired and controllable configuration. This is in particular so since the etching *per se* is most efficient at protruding parts where a higher electric field strength is present. Cutting tool inserts prepared in this way have been found to generate a higher workpiece surface finish and to have a longer life-time in Al-alloy machining operations compared to as-coated diamond cutting tools.

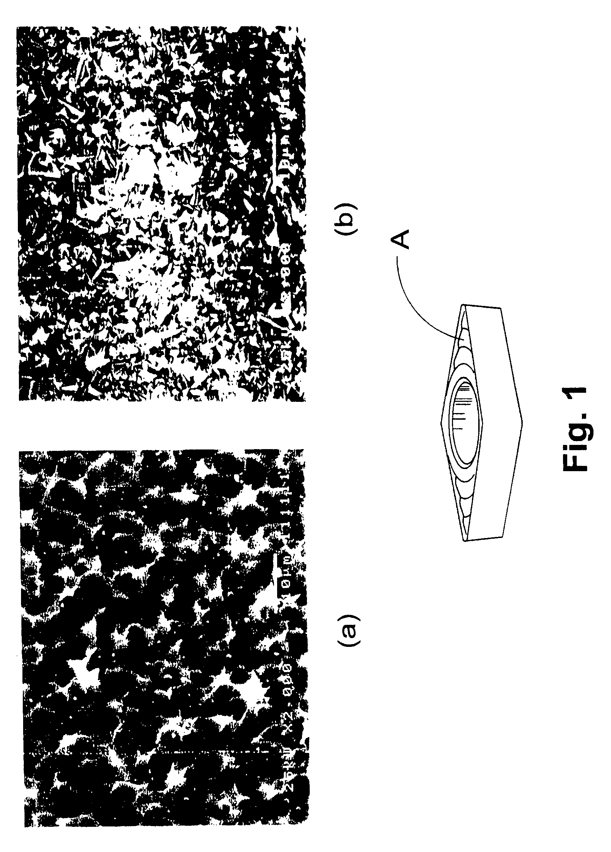

Fig 1 shows in 1500X magnification the topography of the surface of a diamond layer etched according to the invention (a) and before etching (b).

The present invention provides a method for manufacturing of diamond coated cutting tool inserts. The method involves reactive ion etching of the inserts in a gas plasma atmosphere using gases containing CCl₄. The etching of the diamond layer is effective at all sides of the body that are exposed to the plasma.

The etching method according to the invention involves typically a bias voltage at the sample of -200 - -1000 V, preferably -400 - -700 V. The gas pressure is 0.067 - 6.7Pa (0.5 - 50 mtorr), preferably 0.133 - 4Pa (1 - 30 mtorr) and most preferably 0.266 - 2Pa (2 - 15 mtorr).

### Example 1

A WC-6%Co cemented carbide insert provided with a chip breaker and with a cobalt depleted surface zone was diamond coated according to a standard coating procedure in a high current DC-arc diamond coating reactor to a diamond layer thickness of 10 µm. The insert was then etched during 1h in an RIE etching device using CCl₄ as the reactant medium. The process parameters were:
p = 1.2 Pa (9 mtorr)
V_{bias} = -500 V DC

Fig 1a shows the diamond coated surface topography at the point in the chip breaker labelled 'A'.

As a reference insert served a cemented carbide insert prepared as described above but without the RIE treatment. Fig 1b shows the diamond coated surface topography.

The two inserts were subjected to a turning test in an Al-9%Si alloy using the following cutting data:
v = 300 m/min
f = 0.3 mm
a = 3 mm
wet cutting
intermittent cut

The RIE treated diamond coated insert generated a perfectly clean cut without any defects. For the non-etched insert small droplets of work-piece material remained on the machined surface. The size of the droplets was 50-100 µm and they occurred with a density of 50 pcs/mm² giving rise to a less shiny machined surface.

## Claims

1. Method for producing a smooth diamond layer on a cutting tool insert for chipforming machining said insert including a chipformer on its top surface so as to provide chips formed during machining in a desired and controllable configuration
**characterised in**
coating the insert with a diamond layer and
etching it in a reactive ion etching device in a gasplasma atmosphere whereby the etching takes place at all sides of the insert that are exposed to the plasma using gases containing CCl₄ at a pressure of 0.067 - 6.7 Pa (0.5-50 mtorr).

2. Method according to claim 1 **characterised in that** said pressure is 0.133 - 4Pa (1-30 mtorr).

3. Method according to claim 1 **characterised in that** said pressure is 0.266 - 2 Pa (2-15 mtorr).

## Patentansprüche

1. Verfahren zur Herstellung einer glatten Diamantschicht auf einem Schneidwerkzeugeinsatz zur spanabhebenden Bearbeitung, wobei dieser Einsatz einen Spanbildner auf seiner oberen Oberfläche einschließt, um während der Bearbeitung gebildete Späne in einer erwünschten und steuerbaren Gestalt zu bekommen, **dadurch gekennzeichnet, daß** man den Einsatz mit einer Diamantschicht überzieht und sie in einer Ätzeinrichtung mit reaktiven lonen in einer Gasplasmaatmosphäre ätzt, wobei das Ätzen auf allen Seiten des Einsatzes, die dem Plasma ausgesetzt sind, unter Verwendung von CCl₄ enthaltenden Gasen bei einem Druck von 0,067 bis 6,7 Pa (0,5 bis 50 mTorr) stattfindet.

2. Verfahren nach Anspruch 1, **dadurch gekennzeichnet, daß** der Druck 0,133 bis 4 Pa (1 bis 30 mTorr) beträgt.

3. Verfahren nach Anspruch 1, **dadurch gekennzeichnet, daß** der Druck 0,266 bis 2 Pa (2 bis 15 mTorr) beträgt.

## Revendications

1. Procédé de production d'une couche de diamant lisse sur une plaquette d'outil de coupe pour un usinage formant des copeaux, ladite plaquette comprenant un générateur de copeaux sur sa surface supérieure de façon à fournir des copeaux formés pendant l'usinage dans une configuration souhaitée et ajustable,
**caractérisé**
**par** un revêtement de la plaquette avec une couche de diamant et
par une gravure dans un dispositif de gravure par ions réactifs sous une atmosphère de plasma gazeux grâce auquel la gravure se produit sur toutes les faces de la plaquette qui sont exposées au plasma, en utilisant des gaz contenant CCl₄ sous une pression de 0,067 à 6,7 Pa (0,5 à 50 mTorr).

2. Procédé selon la revendication 1 **caractérisé en ce que** ladite pression est de 0,133 à 4 Pa (1 à 30 mTorr).

3. Procédé selon la revendication 1 **caractérisé en ce que** ladite pression est de 0,266 à 2 Pa (2 à 15 mTorr).
